Europäisches Patentamt

European Patent Office

Office européen des brevets

(11) Publication number: **0 491 408 A2**

# EUROPEAN PATENT APPLICATION

(21) Application number: **91202884.2**

(22) Date of filing: **07.11.91**

(51) Int. Cl.5: **H01L 21/76, H01L 21/308**

(30) Priority: **20.11.90 IT 2211390**

(43) Date of publication of application:
**24.06.92 Bulletin 92/26**

(84) Designated Contracting States:
**DE FR GB**

(71) Applicant: **CONSORZIO PER LA RICERCA SULLA MICROELETTRONICA NEL MEZZOGIORNO**
**Stradale Primosole, 50**
**I-95121 Catania(IT)**

(72) Inventor: **Rapisarda, Cirino**
**Contrada Volta di Borello**
**I-95032 Belpasso (Catania)(IT)**

(74) Representative: **Mittler, Enrico et al**
**c/o Marchi & Mittler s.r.l. Viale Lombardia, 20**
**I-20131 Milano(IT)**

(54) Process for making planarized sub-micrometric trenches in integrated circuits.

(57) The process comprises the sequential formation, on a silicon substrate (1), of a lower layer (2) of silicon oxide, of an intermediate layer (3) of silicon nitride and of an upper layer (4, 15) of polycrystalline silicon or of silicon oxide, followed by the etching of the latter for the definition of a window (5, 16) having a width greater than that of the desired trench (8). The window (5, 16) is then narrowed down to the width of the desired trench (8) accomplishing some spacers (11) or oxidizing the layer of polycrystalline silicon (15). There is then executed the etching of the substrate (1) inside said narrow window (7, 14, 18) for the accomplishment of the trench (8), followed by the oxidation of the walls of the trench (8) and by its selfplanarization.

Fig.4

The present invention relates to a process for obtaining planarized sub-micrometric trenches in integrated circuits accomplished with ULSI technology.

It is known that in the technology of ultra-large scale integration, known as ULSI, grooves commonly known as trenches are used which are generally filled with dielectric or polycrystalline silicon and are suitable for insulating densely packed devices. Their use, for the time being especially in bipolar technology, has some advantages such as the reduction of the insulation region, the reduction of the collector-substrate parasitic capacities and, if used in combination with local oxidation silicon (LOCOS) or with shallow trenches, the reduction of the area of connection of the substrate and of the base-collector parasitic capacities.

The accomplishment of a trench, according to the known art, involves the sequential formation, on a silicon substrate, of layers of thermally-grown thin oxide, of silicon nitride and of silicon oxide chemically deposited in the vapour phase. After suitable masking, it also involves the etching of the set of these layers and the subsequent etching of the underlying portion of the substrate for the accomplishment of the trench.

At this point, in order to facilitate the subsequent process steps, the planarization of the trench is accomplished, which, again according to the known art, can occur in two different ways.

A first way involves a selective epitaxial growth on the bottom of the trench.

A second way involves filling the trench, say, with amorphous silicon, polycrystalline silicon or other dielectric, and its subsequent re-etching with controlled chemical etching or polishing techniques.

Currently the width of the trenches, which one would wish to be as small as possible, is limited by the photolithographic systems used for the definition of the geometries.

In this respect it should be noted that the current most advanced photolithographic techniques use photoexposure units, called I-line steppers, which allow the definition of geometries from 0.5 to 0.7 microns.

It should also be considered that the costs of photoexposure units are proportional to their power of resolution, so that the use of G-line steppers with a resolution of the order of one micron has costs that are lower than those of I-line steppers, whose power of resolution, as already said, is higher and thus makes them highly preferred.

The object of the present invention is that of accomplishing a process which allows planarized sub-micrometric trenches to be obtained with a geometry lower than 0.5 microns, using for such object photoexposure units with a power of resolution of the order of one micron, thus less costly.

According to the invention such object is attained with a process for obtaining planarized sub-micrometric trenches in integrated circuits accomplished with ULSI technology, comprising the sequential formation, on a silicon substrate, of a lower layer of silicon oxide, of an intermediate layer of silicon nitride and of an upper layer of silicon oxide or of polycrystalline silicon, the etching of said layers with the terminal point on the substrate, the etching of the underlying substrate for the accomplishment of a trench, the oxidation of the walls of the trench and its filling with planarization dielectric material, characterized in that the etching of said layers is initially limited to the opening of a window in said upper layer and is followed by the formation of a further layer of silicon oxide, which at said window forms a U-shaped cavity having a width that is smaller than that of said window, and by an anisotropic etching of said further layer of oxide, of said layer of nitride and of said lower layer of oxide at said U-shaped cavity so as to uncover a corresponding portion of the substrate having a smaller width than the initial window and equal to that of the desired trench.

According to an embodiment of the process according to the invention said upper layer is constituted by silicon oxide and said further layer is obtained by the direct deposition of silicon oxide.

According to another embodiment of the process, said upper layer is constituted by silicon oxide and said further layer of oxide is obtained by depositing a layer of polycrystalline silicon which forms a U-shaped region at said window opened in said upper layer and then executing its complete oxidation for its transformation into silicon oxide having a greater thickness and consequent narrowing of the U-shaped region.

According to a further embodiment, said upper layer is constituted by polycrystalline silicon and said further layer of oxide is obtained by its total oxidation with the consequent expansion of the layer of polycrystalline silicon and narrowing of the window opened in said upper layer.

In such way, after a first etching on a larger geometry (say, of the order of one micron) accomplished with a unit having a limited cost such as, for example, the G-line steppers, it is possible to exploit oxide spacers which are formed on the sides of the U-shaped region of the further layer of oxide to define with the same units much narrower regions of etching of the substrate, say, of the order of 0.3 microns.

The features of the present invention shall be made more evident by embodiments illustrated as a non-limiting example in the enclosed drawings, wherein:

Fig.s 1 - 6 illustrate successive process steps according to a first embodiment;

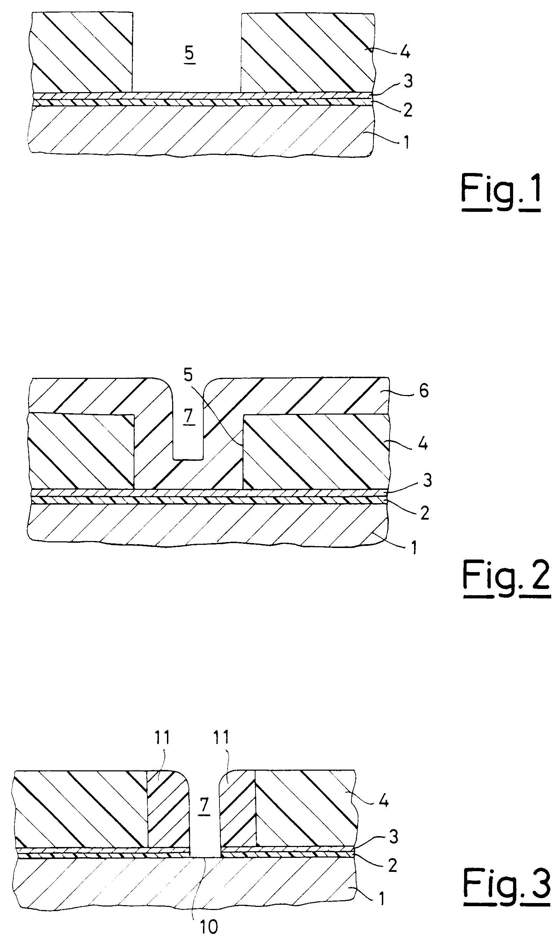

Fig.s 7 - 8 illustrate process steps that are alternative to the single step illustrated in Fig. 2;

Fig.s 9 - 11 illustrate process steps that are alternative to those illustrated in Fig.s 1 - 3.

With reference to Fig.s 1 - 6, according to a first embodiment the process involves the formation, on a substrate of silicon 1, of a lower layer of thermal oxide of silicon 2, over which there is subsequently superimposed by chemical vapour deposition (CVD) a layer of silicon nitride 3, over which there is further superimposed by CVD deposition an upper layer 4 of silicon oxide.

As illustrated in Fig. 1, the upper layer 4 is then etched, through a mask, for the definition of a window 5, inside which the layer of nitride 3 remains integral. The mask which allows the definition of the window 5 is accomplished with a unit of the G-line stepper type, which allows the definition of geometries of the order of one micron and thus, in this case, the definition of a window 5 having an amplitude equal to about 1 micron. The etching of the layer 4, which leads to the window, is executed anisotropically in an alocarbon plasma.

As illustrated in Fig. 2, on the upper layer of silicon oxide 4 there is deposited in a uniform manner, again with CVD technology, a further layer of silicon oxide 6, which at the window 5 forms a U-shaped cavity 7 having a width that is smaller than that of the window 5, say, equal to about 0.3 microns. The resolution is equal to twice the thickness of the layer deposited.

At this point, as illustrated in Fig. 3, the process involved anisotropic etching, in succession, of the layers 6, 3, 2 at the window 5 and down to the surface of the layer 1. Thanks to the features of the anisotropic etching on the sides of the U-shaped cavity, the spacers 11 remain. The previous 1-micron geometry defined by the window 5 is thus reduced to 0.3 microns, that is, equal to twice the thickness of silicon oxide deposited 6. Etching is accomplished, say, with the same plasma described above .

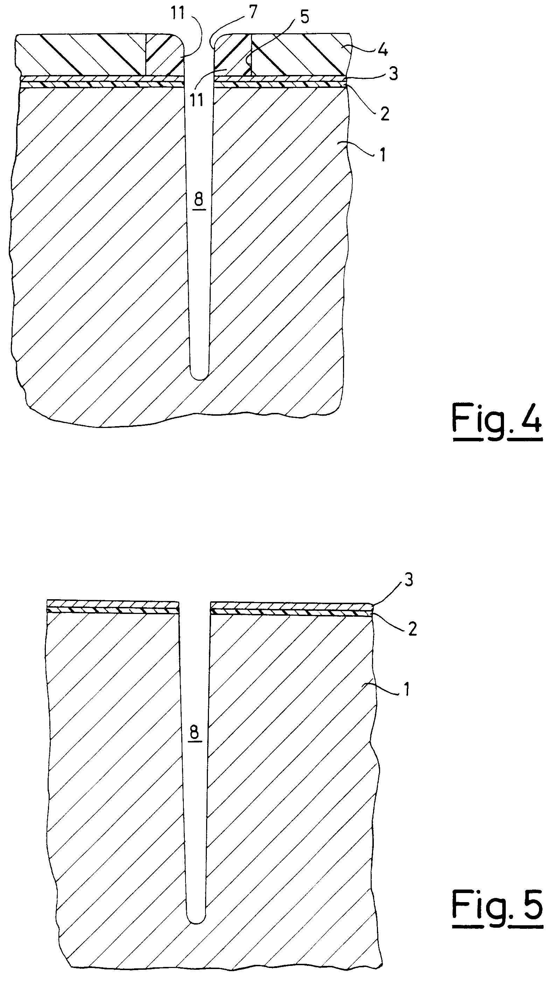

As illustrated in Fig. 4, at this point the etching of the substrate 1 so as to obtain a trench 8 is made. During this step the spacers 11 behave as a mask to define the contours of the trench. The depth of the trench 8 is variable in relation to the devices to be insulated. The material used for etching, which must excise the substrate 1 while leaving the spacers 11 substantially unaltered, is, for example, a mixture of freon 13B and of nitrogen.

As illustrated in Fig. 5, once the trench 8 has been made, the layer of silicon oxide 4 and the spacers 11 are removed.

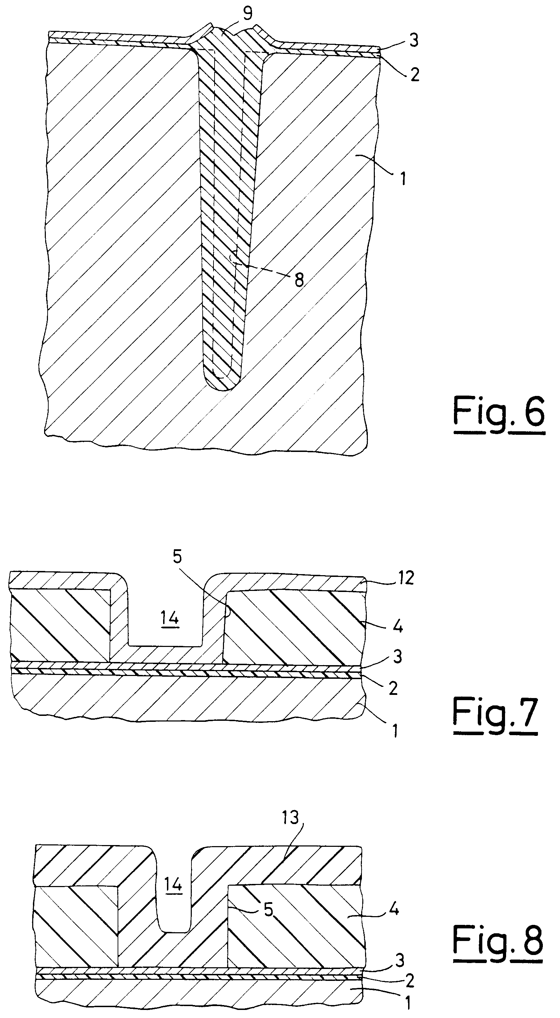

Lastly, as illustrated in Fig. 6, the process involves the oxidation of the walls of the trench 8 with the formation of thermal oxide of silicon 9 and the simultaneous selfplanarization.

More accurately, during the oxidation of the walls of the trench 8 there is an expansion of volume with the formation of a core 9 of silicon oxide, having dimensions about twice those of the trench 8, which selfplanarizes the trench 8.

With reference to Fig.s 7 - 8, starting from the situation illustrated in Fig. 1, an alternative process obtains the further layer of silicon oxide 6 by means of the deposition of a layer of polycrystalline silicon 12, which in the window 5 forms a U-shaped cavity 14 having a width that is greater than that desired for the trench 8.

As illustrated in Fig. 8, this layer of polycrystalline silicon 12 is then completely oxidised and transformed into silicon oxide 13. This involves its thickening and thus a narrowing of the U-shaped cavity 14 down to the width required for the trench 8.

The situation given in Fig. 8 is altogether similar to that illustrated in Fig. 2. From now on the process continues in a manner similar to that illustrated earlier with reference to Fig.s 3 - 6.

As illustrated in Fig.s 9 - 11, a variant of the processes illustrated earlier involves the successive formation, on the substrate 1, of a lower layer of thermal oxide of silicon 2 and of a layer of silicon nitride 3. Over these there is then superimposed a layer of polycrystalline silicon 15. On the polycrystalline silicon 15 there is then defined a window 16 having dimensions of the order of one micron.

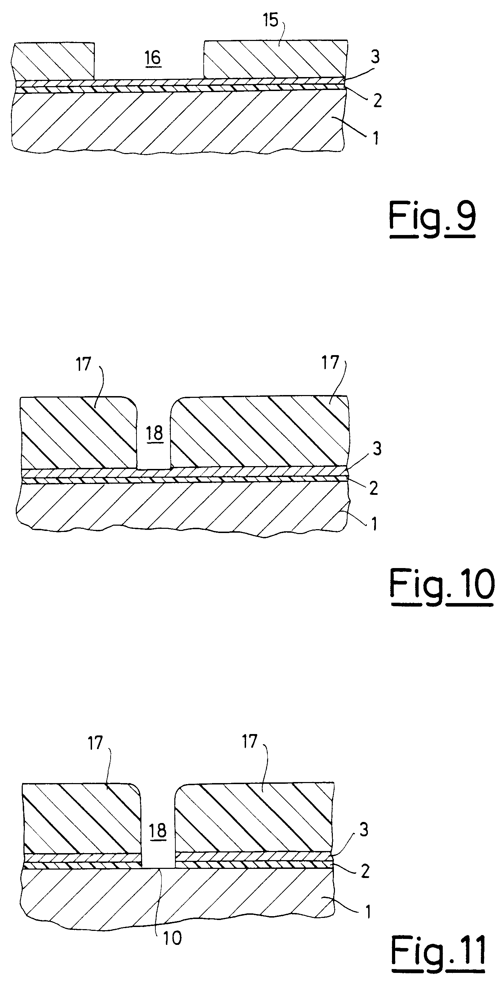

In a subsequent step illustrated in Fig. 10 the layer of polycrystalline silicon 15 is completely oxidized, which is thus transformed into silicon oxide 17. This involves a narrowing of the window 16 until it defines a window 18 of etching on the substrate 1 having dimensions equal to about 0.3 microns. Such window 18 is smaller than the window 16 by the thickness due to the expansion of volume in the oxidation of the polycrystalline silicon.

There follows, as illustrated in Fig. 11, the etching of the layers of nitride 3 and of oxide 2 at the window 18 until a portion 10 of the substrate 1 is uncovered.

The process continues with the steps illustrated in Fig.s 4 - 6.

In the three embodiments, starting with geometries of the order of one micron such as those defined by the windows 5 and 16, it is possible to accomplish narrow windows 7 and 18 suitable for uncovering corresponding portions of the substrate 10 having a width such as to allow the formation of sub-micrometric trenches, say, of the order of 0.3 microns.

These windows are delimited, as illustrated in Fig. 3, by the spacers 11 or, as an altenative, as illustrated in Fig. 11, by the same walls of the layer of silicon oxide 17.

## Claims

1. Process for obtaining planarized sub-micrometric trenches in integrated circuits accomplished with ULSI technology, comprising the sequential formation, on a silicon substrate (1), of a lower layer (2) of silicon oxide, of an intermediate layer (3) of silicon nitride and of an upper layer (4) of silicon oxide or of polycrystalline silicon, the etching of said layers (2, 3, 4) with the terminal point on the substrate (1), the etching of the substrate (1) for the accomplishment of a trench (8), the oxidation of the walls of the trench (8) and its filling with planarization dielectric material, characterized in that the etching of said layers (2, 3, 4) is initially limited to the opening of a window (5, 16) in said upper layer (4) and is followed by the formation of a further layer (6) of silicon oxide, which at said window (5, 16) forms a U-shaped cavity (7, 14, 18) having a width that is smaller than that of said window (5, 16), and by an anisotropic etching of said further layer (6) of oxide, of said layer of nitride (3) and of said lower layer (2) of oxide at said U-shaped cavity (7, 14, 18) so as to uncover a corresponding portion (10) of the substrate (1) having a smaller width than the initial window (5, 16) and equal to that of the desired trench (8).

2. Process according to claim 1, characterised in that said upper layer (4) is constituted by silicon oxide and said further layer (6) is obtained by the direct deposition of silicon oxide.

3. Process according to claim 1, characterised in that said upper layer (4) is constituted by silicon oxide and said further layer (6) of silicon oxide is obtained by depositing a layer (12) of polycrystalline silicon which forms a U-shaped region delimiting a cavity (14) at said window (5) opened in said upper layer (4) and then executing its complete oxidation for its transformation into silicon oxide (13) having a greater thickness and consequent narrowing of said cavity (14).

4. Process according to claim 1, characterised in that said upper layer (4) is constituted by a layer (15) of polycrystalline silicon and said further layer (6) of oxide is obtained by its complete oxidation with the consequent expansion of the layer of silicon oxide and narrowing of the window (16) opened in said upper layer (4).

5. Process according to claim 1, characterised in that the filling of the trench (8) is obtained by extending the oxidation of the walls of the trench (8) up to the formation of a core (9) of silicon oxide which fills the trench completely and gives rise to the selfplanarization of the trench itself.

Fig.1

Fig.2

Fig.3

Fig.4

Fig.5

Fig.6

Fig.7

Fig.8

Fig.9

Fig.10

Fig.11